(19) **Europäisches Patentamt**
**European Patent Office**
**Office européen des brevets**

(11) **EP 4 625 453 A1**

(12) **EUROPEAN PATENT APPLICATION**
published in accordance with Art. 153(4) EPC

(43) Date of publication:
01.10.2025 Bulletin 2025/40

(51) International Patent Classification (IPC):
*H01F 27/245* (2006.01)    *H01F 1/153* (2006.01)
*H01F 17/06* (2006.01)

(21) Application number: 23917593.8

(22) Date of filing: 14.09.2023

(52) Cooperative Patent Classification (CPC):
**H01F 1/153; H01F 17/06; H01F 27/245**

(86) International application number:
**PCT/JP2023/033622**

(87) International publication number:
**WO 2024/154381 (25.07.2024 Gazette 2024/30)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  20.01.2023  JP 2023007679

(71) Applicant: **Kabushiki Kaisha Riken
Tokyo 102-8202 (JP)**

(72) Inventor: **ISHIHARA, Daisuke
Kumagaya-shi, Saitama 360-8522 (JP)**

(74) Representative: **Scott, Stephen John
YUJA IP LAW
4 Centenary House
The Avenue
York YO30 6AU (GB)**

(54) **MAGNETIC CORE AND NOISE FILTER**

(57)    A magnetic core (1) includes a plurality of magnetic laminated pieces (2). Each magnetic laminated piece (2) is formed by stacking a plurality of soft magnetic thin strip members (3) with a bonding portion (4) therebetween. Each magnetic laminated piece (2) includes two longitudinal laminate end faces (5) that form a discontinuous portion (C) and a curved portion (6) that is connected to each of the two longitudinal laminate end faces (5) and is curved in the lamination direction. The magnetic laminated pieces (2) are combined by being abutted against each other in a transverse direction so that the discontinuous portions (C) of adjacent magnetic laminated pieces (2) do not overlap.

*FIG. 1*

**Description**

TECHNICAL FIELD

The present disclosure relates to a magnetic core and a noise filter. The present application claims priority to Japanese Patent Application No. 2023-007679 filed on January 20, 2023, the entire contents of which are incorporated herein by reference.

BACKGROUND

As a conventional magnetic core, a cut core having a structure in which cross-sections of divided circular magnetic bodies are abutted against each other is known as a magnetic core for high-frequency transformers, choke coils, and the like (see, for example, Patent Literature (PTL) 1). PTL 1 discloses that it is preferable to polish the cross-sections of the divided cut core and further perform an etching treatment.

Another conventional magnetic core known for use in noise filters is a laminated core made by cutting a wound core of a plurality of nanocrystalline alloy foils, then impregnating the laminated core with resin and curing the resin (see, for example, PTL 2). PTL 2 discloses that by defining the thickness of the resin layer relative to the thickness of the nanocrystalline alloy foil, the impedance is less likely to decrease even after cutting.

CITATION LIST

Patent Literature

PTL 1: JP H09-027412 A
PTL 2: JP 2021-163772 A

SUMMARY

(Technical Problem)

However, the conventional magnetic cores mentioned above all experience a decrease in impedance and permeability compared to room temperature (normal temperature) when they become hot during use, which may prevent them from exhibiting the expected performance.

It is an aim of the present disclosure to provide a magnetic core and noise filter that can maintain performance even at high temperatures.

(Solution to Problem)

(1) A magnetic core according to the present disclosure includes a plurality of magnetic laminated pieces and is formed by combining the plurality of magnetic laminated pieces, wherein each magnetic laminated piece is formed by stacking a plurality of soft magnetic thin strip members with a bonding portion therebetween, each magnetic laminated piece includes two longitudinal laminate end faces that form a discontinuous portion, and a curved portion that is connected to each of the two longitudinal laminate end faces and is curved in a lamination direction, and the plurality of magnetic laminated pieces is combined by being abutted against each other in a transverse direction so that the discontinuous portions of adjacent magnetic laminated pieces do not overlap.

(2) In the magnetic core according to (1), each magnetic laminated piece can be an annular magnetic laminated piece having the discontinuous portion.

(3) In the magnetic core according to (1), each magnetic laminated piece can be a U-shaped magnetic laminated piece having the discontinuous portion.

(4) In the magnetic core according to any one of (1) to (3), as the thin strip member, at least one of an iron-based nanocrystalline material and an iron-based amorphous material can be used.

(5) In the magnetic core according to any one of (1) to (4), an impedance ratio permeability at 25 °C and 100 kHz is preferably 2000 or more.

(6) In the magnetic core according to any one of (1) to (5), each magnetic laminated piece preferably has an arithmetic mean roughness Ra and a maximum height roughness Rz at an abutment surface at which the magnetic laminated pieces are abutted against each other satisfying Ra ≤ 0.7 μm and Rz ≤ 10 μm.

(7) In the magnetic core according to any one of (1) to (6), each magnetic laminated piece preferably has a flatness FL at an abutment surface at which the magnetic laminated pieces are abutted against each other satisfying FL ≤ 20 μm.

(8) In the magnetic core according to any one of (1) to (7), an angle formed between a center position of the discontinuous portion in one magnetic laminated piece of adjacent magnetic laminated pieces among the plurality of magnetic laminated pieces and a center position of the discontinuous portion in another magnetic laminated piece adjacent to the one magnetic laminated piece is preferably 90° or more and 270° or less.

(9) In the magnetic core according to any one of (1) to (8), a ratio $\Delta Z(25\text{-}85)100k$ of impedance at 85 °C and 100 kHz to impedance at 25 °C and 100 kHz is preferably 80 % or more.

(10) In the magnetic core according to any one of (1) to (9), a ratio $\Delta Z(25\text{-}125)100k$ of impedance at 125 °C and 100 kHz to impedance at 25 °C and 100 kHz is preferably 70 % or more.

(11) A noise filter according to the present disclosure includes any one of the magnetic cores of (1) to (10).

(Advantageous Effect)

According to the present disclosure, a magnetic core and noise filter that can maintain performance even at high temperatures can be provided.

BRIEF DESCRIPTION OF THE DRAWINGS

In the accompanying drawings:

FIG. 1 is a perspective view schematically illustrating a magnetic core according to a first embodiment of the present disclosure;
FIG. 2 is a plan view schematically illustrating the magnetic core of FIG. 1;
FIG. 3 is a perspective view schematically illustrating a magnetic core according to a second embodiment of the present disclosure;
FIG. 4 is a graph illustrating the ratio of the impedance Z at each measurement temperature relative to a reference impedance Z-25, which is the impedance at a measurement temperature of 25 °C, for Examples 1-1 and 1-2 of the present disclosure, and Comparative Examples 1-1 and 1-2 corresponding to Examples 1-1 and 1-2;
FIG. 5 is a perspective view schematically illustrating a conventional magnetic core; and
FIG. 6 is a graph illustrating the ratio Z/Zmax of each impedance Z to the maximum impedance Zmax when the angle θ formed between the center position of the two longitudinal laminate end faces of one of the two magnetic laminated pieces in the magnetic core of FIG. 1 and the center position of the two longitudinal laminate end faces of the other of the two magnetic laminated pieces is shifted from 0° to 360°.

DETAILED DESCRIPTION

The magnetic core and noise filter according to exemplary embodiments of the present disclosure are described below with reference to the drawings.

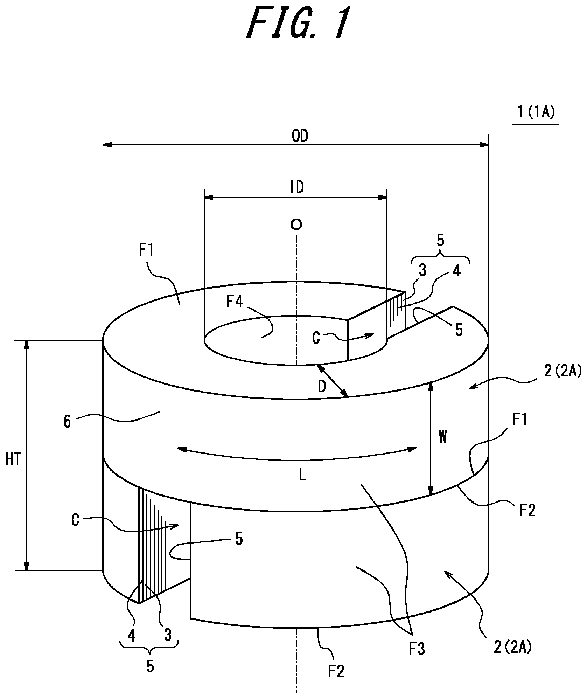

In FIG. 1, a magnetic core 1A according to a first embodiment of the present disclosure is illustrated schematically and in perspective.

The magnetic core 1A includes a plurality of magnetic laminated pieces 2. The magnetic core 1A is formed by combining the plurality of magnetic laminated pieces 2. Each magnetic laminated piece 2 is formed by stacking a plurality of soft magnetic thin strip members 3 (hereinafter simply referred to as "thin strip members 3") via bonding portions 4.

Furthermore, each magnetic laminated piece 2 includes two longitudinal laminate end faces 5 that form a discontinuous portion C, and a curved portion 6 that is connected to each of the two longitudinal laminate end faces 5 and is curved in the lamination direction. The plurality of magnetic laminated pieces 2 are combined by being abutting against each other in the transverse direction so that the discontinuous portions C of adjacent magnetic laminated pieces 2 do not overlap.

Here, in the present embodiment, the "longitudinal direction" refers to the longitudinal direction (length direction) of the thin strip member 3. In the drawings, the longitudinal direction is indicated by the reference sign L. In addition, in the present embodiment, the "transverse direction" refers to the transverse direction (width direction) of the thin strip member 3. In the drawings, the transverse direction is indicated by the reference sign W. Furthermore, in the present embodiment, the "lamination direction" refers to the direction in which the thin strip members 3 are stacked (the thickness direction of the thin strip member 3). In the drawings, the lamination direction is indicated by the reference sign D.

The thin strip member 3 used in the magnetic core 1 is preferably a soft magnetic metal thin strip member made of a soft magnetic material with low coercivity and high permeability. Soft magnetic materials include, for example, soft magnetic metals such as Fe-Ni alloys (permalloy), Fe-Si alloys (silicon steel), amorphous alloys such as Co-based amorphous alloys and Fe-based amorphous alloys, and Fe-based nanocrystalline alloys. In practice, the magnetic core 1 may use at least one of an iron-based nanocrystalline material and an iron-based amorphous material as the thin strip member 3.

When an Fe-based nanocrystalline alloy is used as the soft magnetic metal thin strip member, for example, an alloy having a composition represented by the following general formula can be used: $(Fe_{1-a}M_a)_{100-x-y-z-b-c-d}A_xM'_yM''_zX_bSi_cB_d$ (atomic %) (where in the formula, M is at least one element selected from Co and Ni, A is at least one element selected from Cu and Au, M' is at least one element selected from Ti, V, Zr, Nb, Mo, Hf, Ta, and W, M'' is at least one element selected from Cr, Mn, Sn, Zn, Ag, In, platinum-group elements, Mg, N, and S, X is at least one element selected from C, Ge, Ga, Al, and P, a, x, y, z, b, c, and d are numbers respectively satisfying $0 \le a \le 0.1$, $0.1 \le x \le 3$, $1 \le y \le 10$, $0 \le z \le 10$, $0 \le b \le 10$, $11 \le c \le 17$, and $3 \le d \le 10$, and $65 \le 100 - x - y - z - b - c - d \le 85$). The chemical composition of the Fe-based nanocrystalline alloy is not particularly limited but is preferably, in atomic %, Cu: 0.5 % to 2.0 %, Nb: 1.0 % to 5.0 %, Si: 11.0 % to 15.0 %, and B: 5.0 % to 10.0 %, with the balance substantially consisting of Fe.

However, the material used for the magnetic core 1 is not limited to this as long as the material satisfies the characteristics of soft magnetism.

The magnetic laminate for forming the magnetic laminated piece 2 can be produced by bundling metal foil serving as the raw material for the thin strip members 3 into a predetermined size and shape. Alternatively, the magnetic laminate can be produced by rolling up metal foil serving as the raw material for the thin strip members 3 into a predetermined size and shape.

The filling ratio of the metal foil (the proportion of the thin strip member (magnetic body) 6 in the magnetic laminated piece 2) can be adjusted by the restraining force when bundling the metal foil and the tension when rolling up the metal foil. The filling ratio of the metal foil can, for example, be adjusted in the range of 65 vol% to 85 vol%. If the filling ratio is low, the proportion of the magnetic body is small, resulting in a decrease in permeability. Therefore, if the filling ratio is low, it is necessary to increase the volume of the magnetic laminated piece 2. Conversely, if the filling ratio is high, the distance between the thin strip layers (thin strip members 3) is short, preventing adhesives such as resin from penetrating sufficiently deep. Therefore, if the filling ratio is high, it becomes impossible to perform the curing molding of the magnetic laminated core using the thin strip members 3 and resin.

The metal foil laminated as the thin strip member 3 is subjected to heat treatment to remove distortion during molding. In addition, by subjecting the amorphous alloy to a heat treatment, nanocrystals can be precipitated inside the alloy. Examples of the temperature during heat treatment are temperatures in the range of 350 °C to 700 °C. Examples of the atmosphere in which heat treatment is performed include an inert atmosphere, such as nitrogen or argon, and air.

A bonding portion 4 is interposed between the thin strip layers (thin strip members 3) of the heat-treated magnetic laminated core. This enables the adjacent thin strip members 3 to be fixed together, maintaining the shape of the magnetic laminate. The bonding portion 4 can be formed by inserting adhesive between the thin strip members 3. The adhesive can be either an organic adhesive or an inorganic adhesive. Examples of organic adhesives include acrylic resins, epoxy resins, polyimide resins, silicone resins, and silicone elastomers. Examples of inorganic adhesives include water glass, bentonite-based solvents, alumina-based solvents, and silica-based solvents. The viscosity of the adhesive is preferably set to be 2000 mPa·s or less. If the adhesive has a high viscosity, then to ensure that the adhesive uniformly penetrates (is inserted) between the thin strip members 3, the viscosity can be adjusted by, for example, adjusting the temperature of the resin or adding a diluent such as an organic solvent, or by reducing the pressure when applying the adhesive. Additionally, when stacking a plurality of thin strip members 3 with the bonding portion 4 therebetween, instead of inserting adhesive between the thin strip members 3, adhesive can be applied to the surfaces of the thin strip members 3 before stacking the thin strip members 3.

As mentioned above, the magnetic laminate into which the adhesive has penetrated is subjected to heat treatment to cure the adhesive as needed. The heat treatment temperature or duration needs to be selected under appropriate conditions for the adhesive being used. For example, the heat curing treatment for curing can be performed at a heat treatment temperature of 50 °C to 500 °C for a duration of 0.5 hours to 10 hours. The heat curing treatment can also be performed in multiple stages starting from a low temperature.

The magnetic laminated piece 2 can be produced by providing a notch in the magnetic laminated core that has been bonded and cured. In this case, the notch constitutes the discontinuous portion C. The notch can be provided by, for example, performing cutting processing. The cutting is carried out with a wet-type outer peripheral slicer or the like using a cutting wheel. As the cutting wheel, a GC wheel using a resinoid binder, for example, is suitable. In the cutting wheel, a bonding degree of K to P, a grain size in the range of 80 to 150, and a thickness of the wheel of about 0.5 mm to 1.5 mm are suitable.

Of the side faces of the magnetic laminated piece 2, at least the face that abuts against another magnetic laminated piece 2 (hereinafter also referred to as the "abutment surface") is preferably polished.

Here, the side faces of the magnetic laminated piece 2 refer to a side face F1 on one side in the transverse direction of the magnetic laminated piece 2 or a side face F2 on the other side in the transverse direction of the magnetic laminated piece 2. In other words, the side faces of the magnetic laminated piece 2 refer to faces other than the longitudinal laminate end face 5 of the magnetic laminated piece 2, a side face F3 on one side in the lamination direction of the magnetic laminated piece 2, and a side face F4 on the other side in the lamination direction of the magnetic laminated piece 2.

The arithmetic mean roughness Ra and the maximum height roughness Rz of the polished surface (abutment surface) are preferably Ra $\leq$ 0.7 $\mu$m and Rz $\leq$ 10 $\mu$m, respectively. If the abutment surface is any coarser, the space formed between the abutment surfaces will hinder the flow of magnetic flux, resulting in a decrease in permeability. No lower limits are placed on the arithmetic mean roughness Ra and the maximum height roughness Rz as long as these values of roughness are within a processable range, but ranges allowing mass production are preferred. The ranges Ra $\leq$ 0.35 $\mu$m and Rz $\leq$ 5 $\mu$m are even more preferable.

The flatness FL of the polished surface (abutment surface) preferably satisfies FL $\leq$ 20 $\mu$m. If the flatness FL is greater than 20 $\mu$m, the space formed between the abutment surfaces will hinder the flow of magnetic flux, resulting in a decrease in permeability. Furthermore, the flatness FL of the abutment surface preferably satisfies FL $\leq$ 10 $\mu$m. No lower limit is placed on the flatness FL as long as the value is within a processable range, but a range allowing mass production is preferred.

The magnetic core 1A includes two magnetic laminated pieces 2. In the present embodiment, the two magnetic laminated pieces 2 are combined by having the side face F1 on one side in the transverse direction of one of the two magnetic laminated pieces 2 and the side face F2 on the other side in the transverse direction of the other one of the two magnetic laminated pieces 2 overlap and abut against each other.

Specifically, in the present embodiment, the side face F2 on the other side in the transverse direction (the lower face located at the lower side of the drawing) of one magnetic laminated piece 2 (the magnetic laminated piece located at the upper side of the drawing) of the two magnetic laminated pieces 2 and the side face F1 on the one side in the transverse direction (the upper face located at the upper side of the drawing) of the other magnetic laminated piece 2 (the magnetic laminated piece located at the lower side of the drawing) of the two magnetic laminated pieces 2 are abutted against each other.

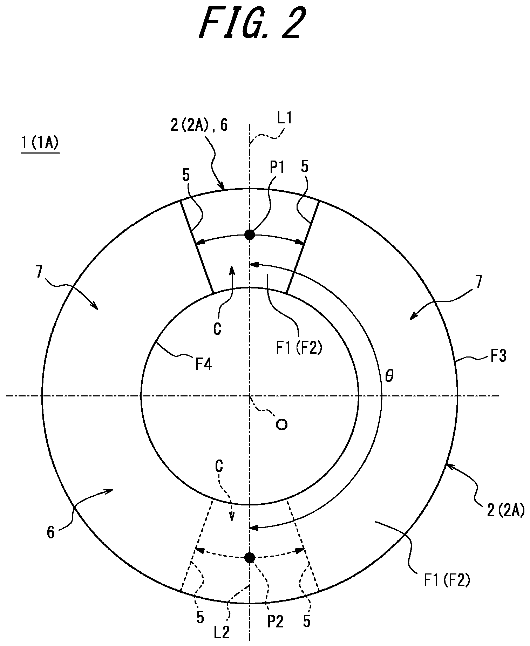

FIG. 2 illustrates the magnetic core 1A in plan view from the lamination direction.

In the magnetic core 1A, the two magnetic laminated pieces 2 are combined so that one discontinuous portion C does not overlap with the other discontinuous portion C in plan view, as illustrated in FIG. 2. Also, in FIG. 2, the center position between the two longitudinal laminate end faces 5 of the magnetic laminated piece 2 is indicated by the reference sign P. The center position P is located in the middle between the two longitudinal laminate end faces 5. In the magnetic core 1A, the center position P is the circumferential middle position about the central axis O of the magnetic core 1A.

According to the present disclosure, an angle θ formed between the center position P1 of the discontinuous portion C in one magnetic laminated piece 2 of adjacent magnetic laminated pieces 2 among the plurality of magnetic laminated pieces 2 and the center position P2 of the discontinuous portion C in another magnetic laminated piece 2 adjacent to the one magnetic laminated piece 2 is preferably 90° or more and 270° or less.

Referring to FIG. 2, the angle θ is the angle formed by a straight line L1 passing through the central axis O of the magnetic core 1A and the center position P1 of one magnetic laminated piece 2 (the magnetic laminated piece located at the front side of the drawing) and a straight line L2 passing through the central axis O of the magnetic core 1A and the center position P2 of the other magnetic laminated piece 2 (the magnetic laminated piece located at the back side of the drawing). If the angle θ exceeds the range of 90° or more and 270° or less, the effective cross-sectional area through which magnetic flux flows decreases, and the impedance or permeability significantly decreases. The angle θ is preferably 120° or more and 300° or less.

Referring to FIG. 2, in the magnetic core 1A, the angle θ formed by the center position P1 of one magnetic laminated piece 2 (the magnetic laminated piece located at the front side of the drawing) and the center position P2 of the other magnetic laminated piece 2 (the magnetic laminated piece located at the back side of the drawing) is 180°.

The magnetic core 1A can be used by being housed in a case. The magnetic core 1A can thus be used as a noise filter, for example.

As the material for the case, PBT (polybutylene terephthalate), PA (polyamide), PPS (polyphenylene sulfide), ABS (acrylonitrile butadiene styrene), ASA (acrylonitrile styrene acrylate), silicone-based resin, silicone-based elastomer, and the like can be used.

The case can, for example, be a hinge case that includes two stackable half-split parts and a hinge that connects the two half-split parts so that they can be opened and closed. The laminated pieces can be inserted between the two half-split parts, and the respective side faces can then be abutted against each other by fixing the two half-split parts.

The case is preferably provided with a weighting mechanism for pressing the magnetic laminated pieces 2 together from at least one of the inside and outside of the case so that the side faces of the magnetic laminated pieces 2 are abutted against each other more reliably. The weighting mechanism can use a plate spring, protrusion, band, or the like made of resin or metal. However, the weighting mechanism is not limited to these examples so long as it can maintain the side faces of the magnetic laminated pieces 2 abutted against each other.

The load applied to the side faces of the laminated pieces by the weighting mechanism is preferably 5 to 100 times the mass of each magnetic laminated piece 2. If the load applied to the side faces of the magnetic laminated piece 2 is small, the side faces (abutment surfaces) of the magnetic laminated pieces 2 may separate due to vibrations or impacts during use. If the side faces of the magnetic laminated pieces 2 separate, the impedance and permeability of the entire magnetic core will sharply decrease. On the other hand, if the load applied to the side faces of the magnetic laminated pieces 2 is large, there is a risk that excessive distortion will occur in the magnetic laminated pieces 2. If excessive distortion occurs in the magnetic laminated pieces 2, it may lead to a decrease in the impedance and permeability of the entire magnetic core. By setting the load applied to the side face of the magnetic laminated piece 2 by the weighting mechanism to 5 to 100 times the mass of each magnetic laminated piece 2, it is possible to suppress the decrease in impedance and permeability of the entire magnetic core caused by the separation of the side faces (abutment surfaces) of the magnetic laminated pieces 2 or excessive distortion occurring in the magnetic laminated pieces 2, as described above.

However, as long as the magnetic laminated pieces 2 can be maintained in contact with each other, it is not necessary to store the magnetic laminated pieces 2 in a case. For example, the magnetic laminated pieces 2 can also be integrated by being wrapped with vinyl tape or cable ties. In these cases as well, the magnetic core integrated with tape, ties, or the like can be used as a noise filter or the like.

The magnetic laminated piece 2 can be an annular magnetic laminated piece having the discontinuous portion C. For example, referring to FIG. 2, in the magnetic core 1A, the magnetic laminated piece 2 is an annular magnetic laminated piece 2A having the discontinuous portion C. Specifically, the magnetic laminated piece 2A includes two longitudinal laminate end faces 5, a semicircular curved portion 6, and arc-shaped curved portions 7 that connect to the two longitudinal laminate end faces 5 and the semicircular curved portion 6. The two curved portions 7 are arc-shaped curved portions 7 that connect to the two longitudinal laminate end faces 5 and the semicircular curved portion 6. As illustrated in FIG. 2, the two curved portions 7 are curved in an arc shape to face each other in a plan view. In the present embodiment, the magnetic laminated piece 2A is a C-shaped magnetic laminated piece in a plan view, as illustrated in FIG. 2.

By combining the magnetic laminated pieces 2A so that the discontinuous portions C do not overlap, a through hole extending along the central axis O of the magnetic core 1A is formed inside the magnetic core 1A.

However, the term "annular" includes a cornered ring with a polygonal shape. That is, the magnetic laminated piece 2A includes shapes in which the discontinuous portion C is provided by cutting out a part of a hollow polygonal shape. However, the magnetic laminated piece 2 is not limited to a circular or polygonal shape with a cut out portion.

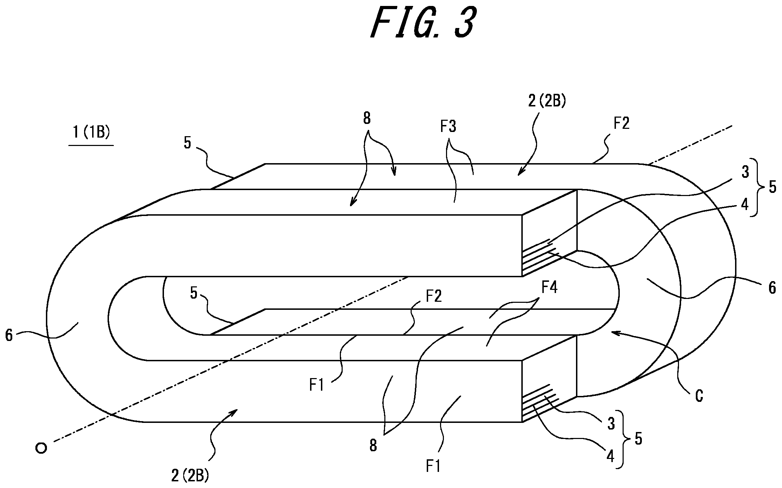

In FIG. 3, a magnetic core 1B according to a second embodiment of the present disclosure is illustrated schematically and in perspective.

In the present embodiment, the magnetic laminated piece 2 is a U-shaped magnetic laminated piece 2B having a discontinuous portion C, as illustrated in FIG. 3. The magnetic laminated piece 2B also includes two longitudinal laminate end faces 5 and a semicircular curved portion 6, similar to the magnetic laminated piece 2 in FIGS. 1 and 2. Furthermore, the magnetic laminated piece 2B includes longitudinal portions 8 that connect to the longitudinal laminate end faces 5 and the semicircular curved portion 6. The two longitudinal portions 8 extend linearly in parallel to each other. That is, the two longitudinal laminate end faces 5 are oriented in the same direction without facing each other.

By combining the magnetic laminated pieces 2B as well so that the discontinuous portions C do not overlap, a through hole extending along the central axis O of the magnetic core 1B is formed inside the magnetic core 1B.

As described above, the shape of the magnetic laminated piece 2 is not limited as long as a through hole can be formed inside the magnetic core 1 by combining a plurality of magnetic laminated pieces 2, that is, as long as the magnetic core 1 as a whole can form a closed circuit that circumferentially surrounds the central axis O. Here, the term "surround" means to make one complete turn around the central axis O. In addition, the term "surround" includes the case of encircling the central axis O an endless manner.

In the magnetic laminated piece 2, any angles may be selected for the angles formed by the side face F1 on one side in the transverse direction, the side face F2 on the other side in the transverse direction, the side face F3 on one side in the lamination direction, the side face F4 on the other side in the lamination direction, and the longitudinal laminate end faces 5.

EXAMPLES

[Example 1-1]

As Example 1-1, two magnetic laminated pieces (2A) with a notch in a portion of an annular shape as illustrated in FIG. 1 were used to create a magnetic core (1A).

In producing the magnetic laminated piece (2A), first, a molten alloy containing, in atomic %, Cu: 1 %, Nb: 3 %, Si: 13.5 %, and B: 9 %, with the remainder being essentially Fe, was quenched by a single roll method to obtain a thin strip Fe-based amorphous alloy having a width of 10 mm and a thickness of 20 $\mu$m as the thin strip member (3).

Next, the aforementioned Fe-based amorphous alloy was wound to form a cylindrical shape with an outer diameter OD of 28.5 mm, an inner diameter ID of 18.0 mm, and a height W of 10 mm. Subsequently, the cylindrical Fe-based amorphous alloy was inserted into a heat treatment furnace maintained at 490 °C under an argon atmosphere and subjected to heat treatment for 10 minutes. As a result, a magnetic laminated body made of an Fe-based nanocrystalline alloy was produced. The obtained magnetic laminated body was then immersed in a solution in which epoxy resin 801N and hardener ST12 manufactured by Mitsubishi Chemical were mixed at a specified ratio, and a vacuum was drawn to -0.1 MPaG, after which the vacuum state was maintained for 10 minutes. Subsequently, by releasing the vacuum state to atmospheric pressure, the resin was impregnated into the magnetic laminated body. The resin-impregnated magnetic laminated body was further left at room temperature for 24 hours and then held at 80 °C in air for 3 hours to cure the resin impregnated in the annular magnetic body.

The magnetic laminated piece (2A) was produced by cutting the magnetic laminated core after resin impregnation to form a notch (discontinuous portion C) as illustrated in FIG. 1. The cutting of the magnetic laminated core was performed manually using a high-speed precision cutting machine Fine Cut HS-100 manufactured by Heiwa Technica Co., with the cutting wheel being Tokuusu Toishi stainless B (outer diameter $\phi$205 mm, inner diameter $\phi$25.4 mm, thickness 0.7 mm) manufactured by Heiwa Technica Co., to produce a discontinuous portion (C) having a width of 10 mm.

The side face of the magnetic laminated piece (2A) was polished. The polishing device used was Tegramin-25 manufactured by Struers. The polishing device was rotated with a revolution of 100 rpm and rotation of 50 rpm in the same direction, with the load set to 15 N. The grit of the polishing paper was gradually refined in order from #320 to #500, #800, #1200, #2000, and #2500.

Through the above series of operations, the magnetic laminated pieces (2A) used in the magnetic core of Example 1-1 were obtained.

The arithmetic mean roughness Ra and the maximum height roughness Rz of the polished surface formed on the side face of the magnetic laminated piece (2A) were measured using a surface roughness measuring instrument SURFCOM 1400G manufactured by Tokyo Seimitsu Co., in accordance with JIS B 0601:2001. The measurement points were at three locations, 90°, 180°, and 270° from the center position P of the discontinuous portion (C), measurements were taken from the inner circumference toward the outer circumference in the lamination direction near the center of the measurement surface, and the mean value was calculated. The magnetic laminated piece 2A measured at this time had a side face (abutment surface) with an arithmetic mean roughness Ra of 0.1 $\mu$m and a maximum height roughness Rz of 2.0 $\mu$m.

The flatness FL of the polished surface provided on the side face of the magnetic laminated piece (2A) refers to the sum of the absolute values of the maximum and minimum values of a cross-sectional curve of the polished surface measured in accordance with JIS B 0601:2001. The flatness FL of the polished surface was measured in the same way as the measurement of surface roughness, using the surface roughness measuring instrument SURFCOM 1400G manufactured by Tokyo Seimitsu Co. The measurement points were at three locations, 90°, 180°, and 270° from the center position P of the discontinuous portion (C), measurements were taken from the inner circumference toward the outer circumference in the lamination direction, with the measurement distance set to 80 % of the lamination thickness excluding 10 % at both ends in the measurement direction, and the mean value of the three locations was calculated. The flatness FL of the magnetic laminated piece 2A measured at this time was 1.5 $\mu$m.

In Example 1-1, the aforementioned two magnetic laminated pieces (2A) were used, and as illustrated in FIG. 2, the angle θ formed by the center positions (P1, P2) of each discontinuous portion (C) was set to 180°, after which the side faces (abutment surfaces) of the two magnetic laminated pieces (2A) were abutted against each other and fixed together using heat-resistant tape.

For the measurement of impedance Z at a frequency of 100 kHz, the 4294A impedance analyzer manufactured by Keysight was used. A heat-resistant lead wire FN-2-0.3SQ manufactured by Nissei Electric Co. was passed through the magnetic core with one turn, and measurements were made using a fixture for lead wires (16047E manufactured by Keysight). During measurement, the two magnetic laminated pieces (2A) were stacked vertically, and a weight of 100 g was placed on the side faces (F1, F2) of the magnetic laminated pieces (2A) to apply a load. The magnetic core (1A) to be measured was placed in a small environmental testing machine SH-222 manufactured by Espec Corp., and the impedance Z was measured at each temperature from 25 °C to 125 °C. The impedance Z at the measurement temperature of 25 °C is referred to as the impedance Z25, and the ratio of the impedance Z at each measurement temperature to this impedance Z25 is defined as $\Delta Z = Z/Z25$.

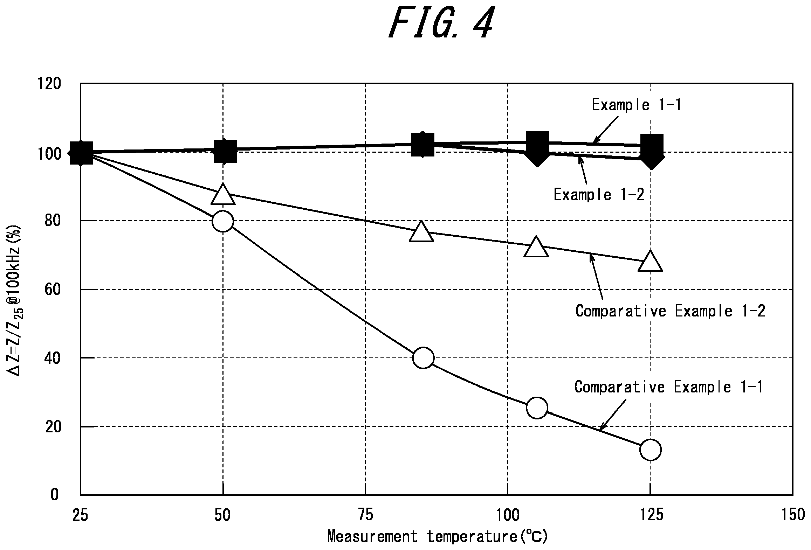

Table 1 below illustrates the measurement results of the impedance Z and the calculated results of $\Delta Z$. Furthermore, FIG. 4 illustrates the results of $\Delta Z$ for Example 1-1.

[Table 1]

| Example 1-1 | |
|---|---|
| Temperature/°C | $\Delta Z$@ 100 kHz |
| 25 | 100% |

(continued)

| Example 1-1 | |
|---|---|
| Temperature/°C | $\Delta Z$@ 100 kHz |
| 50 | 101% |
| 85 | 103% |
| 105 | 103% |
| 125 | 102% |

[Example 1-2]

A molten alloy containing, in atomic %, Si: 13.5 %, and B: 9 %, with the remainder being essentially Fe, was quenched by a single roll method to obtain a thin strip Fe-based amorphous alloy having a width of 10 mm and a thickness of 20 $\mu$m as the thin strip member (3). Next, the aforementioned Fe-based amorphous alloy was wound to form a cylindrical shape with an outer diameter OD of 28.5 mm, an inner diameter ID of 18.0 mm, and a height W of 10 mm. Subsequently, the cylindrical Fe-based amorphous alloy was inserted into a heat treatment furnace maintained at 550 °C under an argon atmosphere, subjected to heat treatment for 10 minutes, and subjected to stress relief. As a result, a magnetic laminated body made of an Fe-based amorphous alloy was produced. Subsequent resin impregnation, cutting, and polishing were carried out in the same manner as in Example 1-1. The measurement method was also the same as in Example 1-1.
Table 2 below illustrates the measurement results of the impedance Z and the calculated results of $\Delta Z$. Furthermore, FIG. 4 illustrates the results of $\Delta Z$ for Example 1-2.

[Table 2]

| Example 1-2 | |
|---|---|
| Temperature/°C | AZ@100 kHz |
| 25 | 100% |
| 50 | 101% |
| 85 | 103% |
| 105 | 100% |
| 125 | 98% |

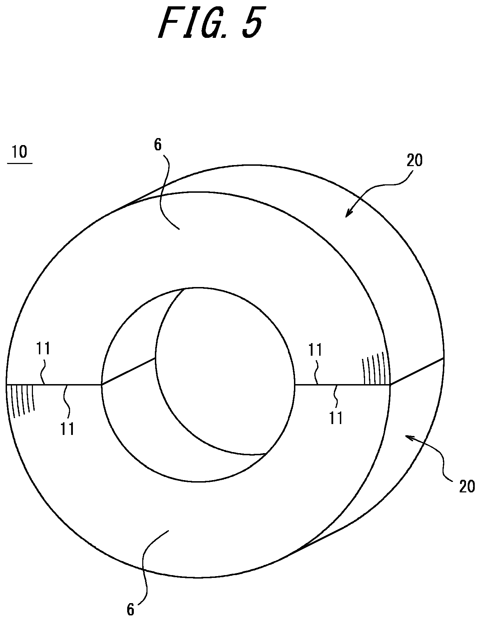

Here, FIG. 5 illustrates a conventional magnetic core 10 schematically and in perspective.

(Comparative Example 1-1)

The magnetic core of Comparative Example 1-1 is based on the magnetic core 10 illustrated in FIG. 5. In Comparative Example 1-1, as in Example 1-1, an Fe-based amorphous alloy was wound and the impregnated resin was allowed to cure to obtain a resin-impregnated magnetic laminated core. However, in Comparative Example 1-1, the magnetic laminated pieces (20) were produced by cutting the resin-impregnated magnetic laminated core in half along the radial direction, as illustrated in FIG. 5. The cut surface (11) of the magnetic laminated piece (20) was polished to #2500, as in Example 1 - 1. Comparative Example 1-1 was produced by abutting the cut surfaces (polished surfaces) 11 of the magnetic laminated pieces (20) against each other and then fixing with heat-resistant tape. The measurement of the overall impedance Z of Comparative Example 1 is the same as in Example 1. However, the weight applied to the cut surface (11) of the magnetic laminated piece (20) was set to 2 kg, and the weight was placed so that the load was applied in the direction perpendicular to the cut surface 11 of the magnetic laminated piece (20).
Table 3 below illustrates the measurement results of the impedance Z and the calculated results of $\Delta Z$. Furthermore, FIG. 4 illustrates the results of $\Delta Z$ for Comparative Example 1-1.

[Table 3]

| Comparative Example 1-1 | |
| --- | --- |
| Temperature/°C | ΔZ@100 kHz |
| 25 | 100% |
| 50 | 80% |
| 85 | 40% |
| 105 | 26% |
| 125 | 14% |

(Comparative Example 1-2)

For the magnetic core of Comparative Example 1-2, the cut surfaces (polished surfaces) 11 of magnetic laminated pieces (20) produced as in Comparative Example 1-1 were abutted against each other and fixed with heat-resistant tape. The weight applied to the cut surface (11) of the magnetic laminated piece (20) was set to 10 kg, and the weight was placed so that the load was applied in the direction perpendicular to the cut surface 11 of the magnetic laminated piece (20).

Table 4 below illustrates the measurement results of the impedance Z and the calculated results of ΔZ. Furthermore, FIG. 4 illustrates the results of ΔZ for Comparative Example 1-2.

[Table 4]

| Comparative Example 1-2 | |
| --- | --- |
| Temperature/°C | ΔZ@100 kHz |
| 25 | 100% |
| 50 | 88% |
| 85 | 77% |
| 105 | 73% |
| 125 | 68% |

Here, referring to Table 1, in Example 1-1, the impedance Z did not decrease even when the measurement temperature increased, and the impedance Z at a measurement temperature of 125 °C was ΔZ = 102 % of the impedance Z at a measurement temperature of 25 °C. Also, referring to Table 2, Example 1-2 is similarly stable even at high temperatures, and the impedance Z at the measurement temperature of 125 °C was ΔZ = 98 % of the impedance Z at the measurement temperature of 25 °C.

On the other hand, as illustrated in Table 3, in Comparative Example 1-1, ΔZ decreases as the measurement temperature rises, and the impedance Z at the measurement temperature of 125 °C was ΔZ = 14 % of the impedance Z at the measurement temperature of 25 °C. As illustrated in Table 4, in Comparative Example 1-2 as well, ΔZ decreases as the measurement temperature rises, and the impedance Z at the measurement temperature of 125 °C was ΔZ = 68 % of the impedance Z at the measurement temperature of 25 °C.

In the case of magnetic cores having the same configuration as a conventional magnetic core, such as Comparative Examples 1-1 and 1-2, even if the weight applied to the cut surface (11) of the magnetic laminated piece (20) was greater than 10 kg, the impedance Z at a measurement temperature of 85 °C did not exceed ΔZ = 80 % of the impedance Z at the measurement temperature of 25 °C, as illustrated in Table 4. Moreover, the impedance Z at the measurement temperature of 125 °C also did not exceed ΔZ = 70 % compared to the impedance Z at the measurement temperature of 25 °C, similar to the data illustrated in Table 4.

In contrast, in the case of magnetic cores with the configuration according to the present disclosure, such as Examples 1-1 and 1-2, the impedance Z at the measurement temperature of 85 °C was ΔZ = 80 % or more of the impedance Z at the measurement temperature of 25 °C, as illustrated in Table 1, without fixing the side faces (abutment surfaces) of the two magnetic laminated pieces (2A) to each other with a load exceeding 10 kg, but rather just by fixing the side faces with heat-resistant tape. The impedance Z at the measurement temperature of 125 °C is also ΔZ = 70 % or more of the impedance Z at the measurement temperature of 25 °C, as illustrated in Table 2.

FIG. 4 is a graph illustrating the ratio of the impedance Z at each measurement temperature relative to a reference impedance Z25, which is the impedance at a measurement temperature of 25 °C, for each of Examples 1-1 and 1-2 and Comparative Examples 1-1 and 1-2. Referring to FIG. 4, it is clear that Examples 1-1 and 1-2 maintain stable performance even at high temperatures as compared to Comparative Examples 1-1 and 1-2.

[Example 2]

The magnetic core of Example 2 is based on the magnetic core 1A illustrated in FIGS. 1 and 2. The magnetic laminated pieces (2A) were also obtained by forming a notch after curing the impregnated resin, as in Examples 1-1 and 1-2. However, the discontinuous portion (notch) C of the magnetic laminated piece (2A) was set to a width of 1 mm. The side face of the magnetic laminated piece (2A) was also polished as in Examples 1-1 and 1-2.

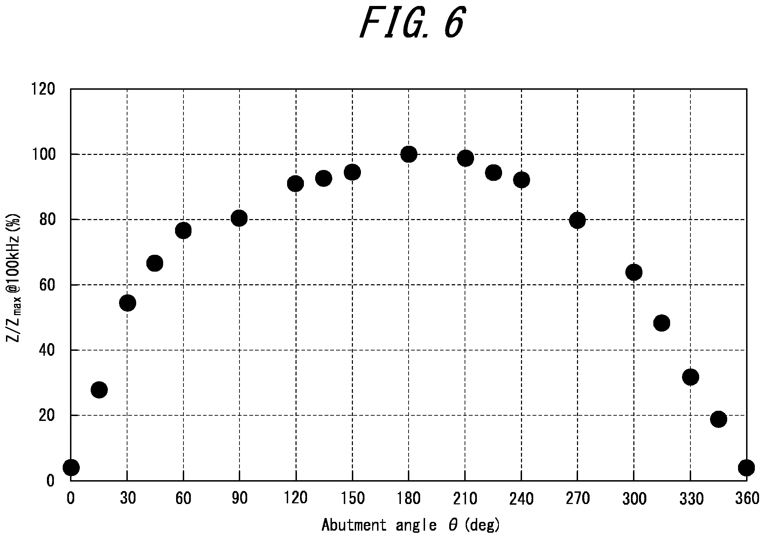

The measurement of the impedance Z at a frequency of 100 kHz was performed using two magnetic laminated pieces (2A) provided with the discontinuous portion (C) of width 1 mm. In Example 2, after abutting the side faces of the magnetic laminated pieces (2A) against each other so that the angle θ formed by the center positions (P1, P2) of the discontinuous portions (C) become a predetermined angle, the side faces of the magnetic laminated pieces (2A) were fixed to each other using heat-resistant tape, a weight of 100 g was further placed on the side faces of the magnetic laminated pieces (2A), and the impedance Z was measured. The maximum value of the impedance Z measured when the angle θ formed by the center position P of each discontinuous portion (C) is shifted from 0° to 360° is defined as Zmax, and the ratio Z/Zmax of the impedance Z measured at each angle θ relative to the maximum value Zmax is illustrated in FIG. 6.

As illustrated in FIG. 6, the impedance Z of Example 2 reaches its maximum value when the angle θ is 180°. Moreover, as illustrated in FIG. 6, the impedance Z of Example 2 decreases sharply as the angle θ becomes smaller. In other words, the impedance Z of Example 2 decreases sharply as θ approaches 0°. The impedance Z of Example 2 also decreases sharply as the angle θ increases. In other words, the impedance Z of Example 2 decreases sharply as θ approaches 360°. In the measurement results of FIG. 6, it is clear that when the angle θ is in the range of 90° to 270°, the impedance Z is 80 % or more of the maximum value Zmax of the impedance Z, and a high impedance can be maintained.

[Example 3]

The magnetic core of Example 3 is also based on the magnetic core 1A illustrated in FIGS. 1 and 2. The magnetic laminated pieces (2A) were produced up to the creation of the discontinuous portion (notch) C with a width of 10 mm, as in Example 1-1. The side face of the magnetic laminated piece (2A) was polished with abrasive paper of grit sizes #800, #1200, #2000, #2500, 1 μm alumina film, and 0.5 μm alumina film to produce the magnetic laminated piece (2A) of Example 3.

The arithmetic mean roughness Ra and maximum height roughness Rz of the abutment surface (polished surface) of the magnetic laminated piece (2A), as well as the flatness FL of the abutment surface, were measured in the same way as in Example 1-1. The measurement of the impedance Z in Example 3 was also performed at each measurement temperature in the same way as in Example 1-1.

The conversion from the impedance Z to the impedance ratio permeability μrz was performed using the following Expression (1).
[Math. 1]

$$\mu r z = Z \times Lm / (2 \pi \mu_0 f \times Ae) \cdots (1)$$

Here, $\mu_0$ is the magnetic permeability in a vacuum, Lm is the mean magnetic path length, f is the measurement frequency, and Ae is the effective cross-sectional area.

As illustrated in FIG. 1, when the outer diameter of the magnetic core is OD, the inner diameter of the magnetic core is ID, and the thickness after combining the magnetic core is HT, the mean magnetic path length Lm and effective cross-sectional area Ae are calculated by the following Expressions (2) and (3), respectively.
[Math. 2]

$$Lm = \pi (OD + ID) / 2 \cdots (2)$$

[Math. 3]

$$Ae = (OD - ID) \times HT / 2 \times dr \cdots (3)$$

In Expression (3), dr is the filling ratio of the magnetic body (thin strip member). The filling ratio in this case was 0.75.

The measurement results of each sample are illustrated in Table 5.

[Table 5]

| Sample name | Finishing grit size | μrz @100kHz | Surface roughness/μm | | Flatness μm | ΔZ(25-85)100k | ΔZ(25-125)100k |
|---|---|---|---|---|---|---|---|
| | | | Ra | Rz | | | |
| Example 3-1 | 0.5 μm alumina film | 14000 | 0.1 | 1.0 | 0.8 | 103% | 99% |
| Example 3-2 | 0.5 μm alumina film | 16500 | 0.1 | 0.7 | 0.5 | 100% | 100% |
| Example 3-3 | 1.0 μm alumina film | 13200 | 0.2 | 0.5 | 1.0 | 102% | 103% |
| Example 3-4 | 1.0 μm alumina film | 12800 | 0.2 | 0.8 | 0.8 | 102% | 100% |
| Example 3-5 | #2500 SiC | 11400 | 0.1 | 2.0 | 1.0 | 103% | 102% |
| Example 3-6 | #2500 SiC | 10500 | 0.1 | 2.2 | 1.0 | 100% | 101% |
| Example 3-7 | #2000 SiC | 9200 | 0.2 | 2.8 | 4.5 | 99% | 97% |
| Example 3-8 | #2000 SiC | 8800 | 0.2 | 2.0 | 5.0 | 95% | 95% |
| Example 3-9 | #1200 SiC | 7500 | 0.2 | 3.0 | 7.3 | 92% | 90% |
| Example 3-10 | #1200 SiC | 7200 | 0.3 | 3.0 | 8.6 | 89% | 84% |
| Example 3-11 | #800 SiC | 5600 | 0.2 | 6.0 | 12.3 | 84% | 75% |
| Example 3-12 | #800 SiC | 4300 | 0.3 | 9.0 | 15.0 | 85% | 73% |
| Comparative Example 3-1 | #500 SiC | 1800 | 0.8 | 10.0 | 22.0 | 78% | 68% |
| Comparative Example 3-2 | #500 SiC | 1750 | 0.7 | 11.0 | 25.5 | 77% | 65% |
| Comparative Example 3-3 | #500 SiC | 1700 | 0.6 | 9.0 | 29.0 | 75% | 66% |
| Comparative Example 3-4 | #320 SiC | 1500 | 0.8 | 12.0 | 30.7 | 73% | 62% |
| Comparative Example 3-5 | #320 SiC | 1400 | 0.9 | 9.0 | 32.0 | 70% | 65% |

(Comparative Example 3)

The magnetic core of Comparative Example 3 is also based on the magnetic core 1A illustrated in FIGS. 1 and 2. The magnetic laminated pieces (2A) were produced up to the creation of the discontinuous portion (notch) C with a width of 10 mm, as in Example 1. The side face of the magnetic laminated piece (2A) was polished with abrasive paper of grit sizes #320 and #500 to produce the magnetic laminated piece of Comparative Example 3. In Comparative Example 3, the measurements were the same as in Example 3. The measurement results of each sample are illustrated in Table 5.

Looking at Examples 3-1 to 3-12 in Table 5, the finer the finishing grit size of the polishing is, the higher the impedance ratio permeability $\mu_{rz}$ is, and the surface roughness and flatness at this time are good.

On the other hand, looking at Comparative Examples 3-1 to 3-4, the surface roughness (Ra, Rz) and flatness (FL) deteriorate, and the impedance ratio permeability $\mu_{rz}$ decreases. Looking at Examples 3-1 to 3-12, it can be seen that the ratio $\Delta Z$ of the impedance Z at each measurement temperature to the impedance Z-25 at 25°C and 100 kHz is maintained at 80 % or more at 85 °C and 70 % or more at 125 °C, and hence stable performance is maintained even at high temperatures.

[Example 4]

The magnetic core of Example 4 is based on the magnetic core 1B illustrated in FIG. 3. Example 4 was produced by using two magnetic laminated pieces (2B).

In producing the magnetic laminated piece (2B), first, a molten alloy containing, in atomic %, Cu: 1 %, Nb: 3 %, Si: 13.5 %, and B: 9 %, with the remainder being essentially Fe, was quenched by a single roll method to obtain a thin strip Fe-based amorphous alloy having a width of 10 mm and a thickness of 20 $\mu$m as the thin strip member (3).

Next, the aforementioned Fe-based amorphous alloy was wound around a core having a height of 10 mm, a length of 110 mm, a width of 10 mm, and a longitudinal end radius of 5 mm, to produce a flat wound magnetic body with a longitudinal outer diameter of 130 mm, a transverse outer diameter of 30 mm, and a height of 10 mm. This was inserted into a heat treatment furnace maintained at 490 °C under an argon atmosphere and subjected to heat treatment for 10 minutes. Subsequently, the core material was removed from the flat wound core, and the treatment from resin impregnation to curing was performed as in Example 1. The cutting of the flat magnetic laminated core after resin impregnation was also performed as in Example 1. However, the cutting position was set to split the flat magnetic laminated core in half at the center position in the longitudinal direction, resulting in a U-shaped magnetic laminated piece (2B). The polishing of the U-shaped magnetic laminated piece (2B) was performed as in Example 1 by polishing the side face of the magnetic laminated piece (2B). In Example 4, two magnetic laminated pieces (2B) were used. The magnetic core of Example 4 was produced by abutting the side faces (polished surfaces) of the magnetic laminated pieces (2B) against each other so that the angle between the central positions of the discontinuous portions (C) of each magnetic laminated piece (2B) was 180°, as illustrated in FIG. 3, and then fixing with heat-resistant tape.

The magnetic core 1B illustrated in FIG. 3 can be used as a noise countermeasure core, particularly by insertion of a conductive element that is wide in the horizontal width direction, such as a flat cable or bus bar. According to the magnetic core 1B, while reducing the dimensions in the vertical width direction (one of the two directions perpendicular to the central axis O), it is possible to apply a conductive element that is wide in the horizontal width direction (the other one of the two directions perpendicular to the central axis O). In addition, according to the magnetic core 1B, the two magnetic laminated pieces 2B that are combined with each other can be separated in the horizontal width direction along the longitudinal portions 8. Therefore, according to the magnetic core 1B, when using the magnetic core 1B as a transformer for power conversion, the two magnetic laminated pieces 2B can be separated in the horizontal direction, making it easier to insert a pre-wound coil. As a result, according to the magnetic core 1B, it becomes easier to automate mounting onto a cable and winding around the magnetic core 1B, thus also improving workability.

Incidentally, the conventional magnetic core 10 illustrated in FIG. 5 experiences a decrease in impedance and permeability compared to room temperature (normal temperature) when it becomes hot during use, which may prevent it from exhibiting the expected performance. One of the reasons for this is that the conventional magnetic core 10 is made by cutting an annular magnetic laminated body with the thin strip member 3 wound therein into two pieces, and the cut surfaces are abutted against with each other.

Specifically, when the magnetic core 10 becomes hot during use, the contact state between the cut surfaces of the magnetic laminated pieces 20 deteriorates due to the deformation of the magnetic laminated pieces 20 caused by heat. This deterioration of the contact state is one of the causes of the decrease in impedance and permeability compared to room temperature.

In contrast, the magnetic core 1 includes the plurality of magnetic laminated pieces 2 that have the two longitudinal laminate end faces 5 forming the discontinuous portion C and the curved portion 6 that is curved in the lamination direction between the two longitudinal laminate end faces 5, and these magnetic laminated pieces 2 are abutted against each other at the side faces of the magnetic laminated pieces 2 so that their discontinuous portions C do not overlap.

The surfaces other than the longitudinal laminate end faces 5, i.e., the side faces of the magnetic laminated piece 2, undergo less surface deformation due to temperature changes as compared to the longitudinal laminate end faces 5.

On the other hand, the magnetic laminated piece 2 with a discontinuous portion C cannot form a closed magnetic circuit by itself, as in a conventional configuration. However, if the magnetic laminated pieces 2 are abutted against each other at their side faces so that their discontinuous portions C do not overlap, a closed magnetic circuit can be formed in the magnetic core 1 as a whole. As a result, the magnetic core 1 can function as a magnetic core, like a conventional configuration.

Therefore, according to the magnetic core 1, by abutting the side faces of the magnetic core 1 against each other to form a closed magnetic circuit, a magnetic core that is less likely to change in impedance and permeability even at high temperatures can be obtained.

In the case of the magnetic core 10 in FIG. 5, a metal spring, metal band, or the like may be used to apply a large load to the cut surfaces of the magnetic laminated pieces 20 to fix the cut surfaces to each other. However, such a large load is undesirable as it leads to an increase in the distortion of the magnetic laminated pieces 20. It is also possible to add a cooling mechanism to lower the temperature of the magnetic laminated pieces 20. However, the addition of a cooling mechanism complicates the structure of the magnetic core. The addition of a cooling mechanism also leads to an increase in the volume and weight of the entire magnetic core, and to an increase in costs. For these reasons, the addition of a cooling mechanism is also undesirable.

In contrast, a magnetic core in which impedance and magnetic permeability are less likely to change can be obtained without applying a large load to the magnetic laminated pieces 2. In addition, since the magnetic core 1 is less likely to change in impedance and permeability even at high temperatures, the addition of a cooling mechanism is also unnecessary.

Since the magnetic core 1 is provided with a plurality of divided magnetic laminated pieces 2, similar to the conventional magnetic core 10, it is easier to automate mounting onto a cable and winding around the magnetic core compared to when a single circular magnetic laminate is used, and good workability is also maintained.

As described above, according to the present disclosure, by using high permeability soft magnetic thin strip members 3 in the magnetic laminated piece 2, it is possible to obtain a magnetic core with high impedance and permeability, and since the discontinuous portion C exists in part of the magnetic laminated piece 2, the magnetic core has excellent workability for mounting to cables and for winding onto the magnetic core and can be used stably even in high-temperature environments.

INDUSTRIAL APPLICABILITY

The present magnetic core can be attached to the power cables of electronic devices such as automobiles, power generation and supply equipment, communication devices, and OA/FA equipment, and can be used as a noise countermeasure core (noise filter) to suppress noise generated within these electronic devices or externally generated noise that propagates through the cables. In addition, by winding a wire around the magnetic core as a primary winding, the magnetic core can be used as a common mode choke coil that is mounted on an electronic substrate to suppress noise. Furthermore, by winding a wire around the magnetic core as both a primary and secondary winding, the magnetic core can also be used as a transformer for power conversion.

The above merely represents illustrative embodiments of the present disclosure, and various modifications are possible within the scope of the appended claims. For example, the configurations (subject matter) used in each embodiment and each example can be added to or substituted for each other.

REFERENCE SIGNS LIST

1    Magnetic core
1A   Magnetic core (first embodiment)
1B   Magnetic core (second embodiment)
2    Magnetic laminated piece
2A   Magnetic laminated piece (C-shaped)
2B   Magnetic laminated piece (U-shaped)
3    Thin strip member
4    Bonding portion
5    Longitudinal laminate end face
6    Semi-circular curved portion
7    Arc-shaped curved portion
8    Longitudinal portion
10   Magnetic core (conventional)
11   Cut surface
20   Magnetic laminated piece (conventional)
F1   Side face on one side in transverse direction of magnetic laminated piece 2 (side face of magnetic laminated piece)

F2    Side face on other side in transverse direction of magnetic laminated piece 2 (side face of magnetic laminated piece)

**Claims**

1.  A magnetic core comprising a plurality of magnetic laminated pieces and formed by combining the plurality of magnetic laminated pieces, wherein

each magnetic laminated piece is formed by stacking a plurality of soft magnetic thin strip members with a bonding portion therebetween,
each magnetic laminated piece comprises two longitudinal laminate end faces that form a discontinuous portion, and a curved portion that is connected to each of the two longitudinal laminate end faces and is curved in a lamination direction, and
the plurality of magnetic laminated pieces is combined by being abutted against each other in a transverse direction so that the discontinuous portions of adjacent magnetic laminated pieces do not overlap.

2.  The magnetic core according to claim 1, wherein each magnetic laminated piece is an annular magnetic laminated piece comprising the discontinuous portion.

3.  The magnetic core according to claim 1, wherein each magnetic laminated piece is a U-shaped magnetic laminated piece comprising the discontinuous portion.

4.  The magnetic core according to claim 1, wherein as the thin strip member, at least one of an iron-based nanocrystalline material and an iron-based amorphous material is used.

5.  The magnetic core according to claim 1, wherein an impedance ratio permeability at 25 °C and 100 kHz is 2000 or more.

6.  The magnetic core according to claim 1, wherein each magnetic laminated piece has an arithmetic mean roughness Ra and a maximum height roughness Rz at an abutment surface at which the magnetic laminated pieces are abutted against each other satisfying $Ra \leq 0.7 \ \mu m$ and $Rz \leq 10 \ \mu m$.

7.  The magnetic core according to claim 1, wherein each magnetic laminated piece has a flatness FL at an abutment surface at which the magnetic laminated pieces are abutted against each other satisfying $FL \leq 20 \ \mu m$.

8.  The magnetic core according to claim 1, wherein an angle formed between a center position of the discontinuous portion in one magnetic laminated piece of adjacent magnetic laminated pieces among the plurality of magnetic laminated pieces and a center position of the discontinuous portion in another magnetic laminated piece adjacent to the one magnetic laminated piece is 90° or more and 270° or less.

9.  The magnetic core according to claim 1, wherein a ratio $\Delta Z(25\text{-}85)100k$ of impedance at 85 °C and 100 kHz to impedance at 25 °C and 100 kHz is 80 % or more.

10.  The magnetic core according to claim 1, wherein a ratio $\Delta Z(25\text{-}125)100k$ of impedance at 125 °C and 100 kHz to impedance at 25 °C and 100 kHz is 70 % or more.

11.  A noise filter comprising the magnetic core according to any one of claims 1 to 10.

## FIG. 1

# FIG. 2

# FIG. 3

## FIG. 4

EP 4 625 453 A1

# FIG. 5

# FIG. 6

EP 4 625 453 A1

# EP 4 625 453 A1

## INTERNATIONAL SEARCH REPORT

International application No.

**PCT/JP2023/033622**

### A. CLASSIFICATION OF SUBJECT MATTER

*H01F 27/245*(2006.01)i; *H01F 1/153*(2006.01)i; *H01F 17/06*(2006.01)i
FI:  H01F27/245 155; H01F17/06 F; H01F1/153 133

According to International Patent Classification (IPC) or to both national classification and IPC

### B. FIELDS SEARCHED

Minimum documentation searched (classification system followed by classification symbols)

H01F27/245; H01F1/153; H01F17/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | Microfilm of the specification and drawings annexed to the request of Japanese Utility Model Application No. 102583/1990 (Laid-open No. 59925/1992) (MITSUI SEKIYU KAGAKU KOGYO KABUSHIKI KAISHA) 22 May 1992 (1992-05-22), p. 9, lines 8-12, fig. 4 | 1-2, 4, 8, 11 |
| A | | 3, 5-7, 9-10 |
| A | Microfilm of the specification and drawings annexed to the request of Japanese Utility Model Application No. 82753/1972 (Laid-open No. 40707/1974) (MEIDENSHA CORPORATION) 10 April 1974 (1974-04-10) | 1-11 |

☐ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 November 2023** | **28 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/033622**

| Patent document cited in search report | Publication date (day/month/year) | Patent family member(s) | Publication date (day/month/year) |
|---|---|---|---|
| JP 4-59925 U1 | 22 May 1992 | (Family: none) | |
| JP 49-40707 U1 | 10 April 1974 | (Family: none) | |

Form PCT/ISA/210 (patent family annex) (January 2015)

**EP 4 625 453 A1**

**Patent documents cited in the description**

- JP 2023007679 A
- JP H09027412 A
- JP 2021163772 A